# EUROPEAN PATENT APPLICATION

(11) **EP 4 653 899 A1**
(43) Date of publication of application: **26.11.2025**
(21) Application number: 24744586.9
(22) Date of filing: 12.01.2024
(51) Int. Cl.: G01R 31/50, G01R 31/392, G01R 31/396, G01R 31/3842, H01M 10/48, H02J 7/00

(54) **BATTERY ABNORMALITY DETECTION SYSTEM, BATTERY ABNORMALITY DETECTION METHOD, BATTERY ABNORMALITY DETECTION PROGRAM, AND RECORDING MEDIUM HAVING BATTERY ABNORMALITY DETECTION PROGRAM RECORDED THEREON**

(30) Priority: 20.01.2023 JP 2023007303
(71) Applicant: Panasonic Intellectual Property Management Co., Ltd., Kadoma-shi, Osaka 571-0057 (JP)
(72) Inventor: ITAKURA, Yusuke, Kadoma-shi, Osaka 571-0057 (JP); TAKEDA, Mutsuhiko, Kadoma-shi, Osaka 571-0057 (JP)
(74) Representative: Novagraaf International SA
(86) International application number: PCT/JP2024/000602
(87) International publication number: WO 2024/154663

(57) **Abstract**

A data processing unit is configured to calculate, on a time-series basis, the voltage difference between a reference voltage and the minimum voltage of a plurality of cells or cell blocks included in a battery pack and connected in series. A determination unit is configured to, when an increasing rate of the voltage difference is equal to or greater than a threshold, determine that a micro short circuit has occurred in the cells or cell blocks having the minimum voltage. The data processing unit calculates the increasing rate of the voltage difference by using voltage data in a period in which the State-Of-Charge (SOC) of the battery pack is within a predetermined SOC range.

## Description

### BACKGROUND

### 1. Technical Field

The present disclosure relates to a battery abnormality detection system, a battery abnormality detection method, and a battery abnormality detection program, each being configured to detect the abnormal state of a battery.

### 2. Description of the Related Art

In secondary battery cells such as lithium-ion batteries, a micro short circuit sometimes occurs due to contact between a positive electrode and a negative electrode that is caused by the displacement of a separator, due to the generation of a conductive path that is caused by contamination with a foreign matter in a cell, or due to other factors. The micro short circuit sometimes causes overheating and thereby becomes a dead short circuit due to a change in the orientation of the foreign matter or other factors.

In applications such as EVs, a battery pack including a plurality of cell blocks connected in series, each of the cell blocks including a plurality of cells connected in parallel, is often used. Especially an EV equipped with a large motor includes a larger number of cell blocks connected in series. For a battery pack having the above-described configuration, there is a method of determining a micro short circuit in the battery pack by detecting a tendency for the difference between the maximum and minimum cell block voltages of the cell blocks to increase.

However, in this method, when the difference in the state of charge (SOC) between cell blocks or the difference in the state of health (SOH) between the cell blocks is relatively large, the voltage difference greatly changes in response to a SOC change, and therefore it is difficult to distinguish between the voltage difference caused by the SOC change and the voltage difference caused by a micro short circuit, and accordingly false detection easily occurs.

In Patent Literature 1, which has been already filed, the present inventors discloses a method of taking a tangent to the SOC-OCV curve of a cell at a specific point as a linear function, inputting a cell voltage to the linear function, and deriving a normalized cell voltage, and thereby reducing the effect of a SOC range on the cell voltage. In the SOC-OCV curve, the OCV drops sharply in a low SOC range, and accordingly, in the low SOC range, a small change in capacitance between cell blocks causes a great change in voltage. By using the linear function corresponding to the SOC-OCV curve, variations in the sensitivity of voltage change due to the SOC range can be eliminated.

This method assumes that the SOC-OCV curve of a high quality cell is present and the method cannot be used when the SOC-OCV curve is unclear. Furthermore, when the SOC-OCV curve changes greatly from the initial state thereof due to deterioration, detection accuracy decreases.

### Citation List

Patent Literature 1: WO 20/021888

### SUMMARY

The present disclosure has been made in view of these circumstances, and an object of the present disclosure is to provide a technology to highly accurately detect a micro short circuit in a battery pack including a plurality of cells or cell blocks connected in series.

To solve the above-mentioned problem, a battery abnormality detection system according to one aspect of the present disclosure includes: a data acquisition unit configured to acquire a plurality of voltages, including the minimum voltage, of a plurality of cells included in a battery pack and connected in series, or a plurality of voltages, including at least the minimum voltage, of a plurality of cell blocks included in a battery pack and connected in series, each of the cell blocks including a plurality of cells, and time-series data of the SOC of the battery pack; a data processing unit configured to calculate the voltage difference between a reference voltage and the minimum voltage of the cells or the cell blocks on a time-series basis; and a determination unit configured to determine that, when an increasing rate of the voltage difference is equal to or greater than a threshold, a micro short circuit has occurred in the cells or the cell blocks having the minimum voltage. The data processing unit calculates the increasing rate of the voltage difference by using voltage data in a period in which the SOC of the battery pack is within a specific SOC range.

Note that any combination of the above-mentioned constituents and what is obtained by converting between a device, a system, a method, a computer program, and a recording medium concerning the expression of the present disclosure are also effective as aspects of the present disclosure.

According to the present disclosure, a micro short circuit having occurred in a battery pack including a plurality of cells or cell blocks connected in series can be detected with high accuracy.

### BRIEF DESCRIPTION OF THE DRAWINGS

FIG. 1 is a diagram illustrating a battery abnormality detection system according to an embodiment.
FIG. 2A is a diagram illustrating the configuration of an assembled battery system including a plurality of single cells connected in series.
FIG. 2B is a diagram illustrating the configuration of an assembled battery system including a plurality of cell blocks connected in series.
FIG. 3A is a diagram illustrating changes in the cell voltage and the voltage difference of a battery pack in which a micro short circuit has occurred.
FIG. 3B is a diagram illustrating changes in the cell voltage and the voltage difference of a battery pack in which a large SOC difference has occurred.
FIG. 3C is a diagram illustrating changes in the cell voltage and the voltage difference of a battery pack in which a large SOH difference has occurred.
FIG. 4 is a diagram illustrating a method of normalizing a cell voltage by producing a linear line that approximates the SOC-OCV curve of a cell.
FIG. 5 is a diagram illustrating changes in the voltage of a medium SOC cell, the voltage of a low SOC cell, and the voltage difference when the voltage of the medium SOC cell and the voltage of the low SOC are normalized using the linear line illustrated in FIG. 4.
FIG. 6 is a diagram illustrating a tabulation example of the number of sampling data in each SOC range.
FIG. 7A is a diagram illustrating the way of selecting a usable SOC range, based on changes in the maximum cell voltage, the minimum cell voltage, and the voltage difference between the maximum and minimum cell voltages.
FIG. 7B is a diagram in which voltage data of SOC ranges other than the usable SOC range are deleted.
FIG. 7C is a diagram obtained by performing linear interpolation for a section of the deleted voltage data.
FIG. 8 is a flowchart illustrating Operation Example 1 of the battery abnormality detection system according to the embodiment.
FIG. 9 is a flowchart illustrating Operation Example 2 of the battery abnormality detection system according to the embodiment.

### DETAILED DESCRIPTIONS

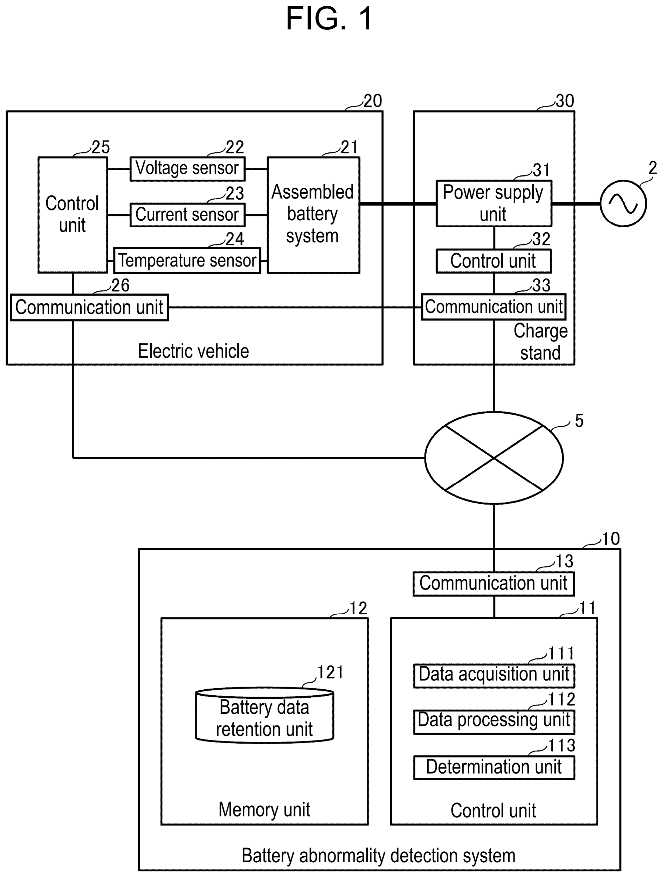

FIG. 1 is a diagram illustrating battery abnormality detection system 10 according to an embodiment. Battery abnormality detection system 10 is a system to detect whether a micro short circuit has occurred in a cell of a battery pack installed in electric vehicle 20.

Battery abnormality detection system 10 may be built, for example, on a company's own server installed in a company's own facility or a data center of a company that provides analysis service for the battery pack installed in electric vehicle 20. Alternatively, battery abnormality detection system 10 may be built on a cloud server to be used based on cloud service. Alternatively, battery abnormality detection system 10 may be built on a plurality of servers respectively distributed to a plurality of locations (the data center and the company's own facility). The servers may be any of a combination of a plurality of company's own servers, a combination of a plurality of cloud servers, and a combination of a company's own server and a cloud server.

Assembled battery system 21 included in the battery pack installed in electric vehicle 20 provides power to a motor for driving (not illustrated). Assembled battery system 21 includes a plurality of single cells or cell blocks connected in series.

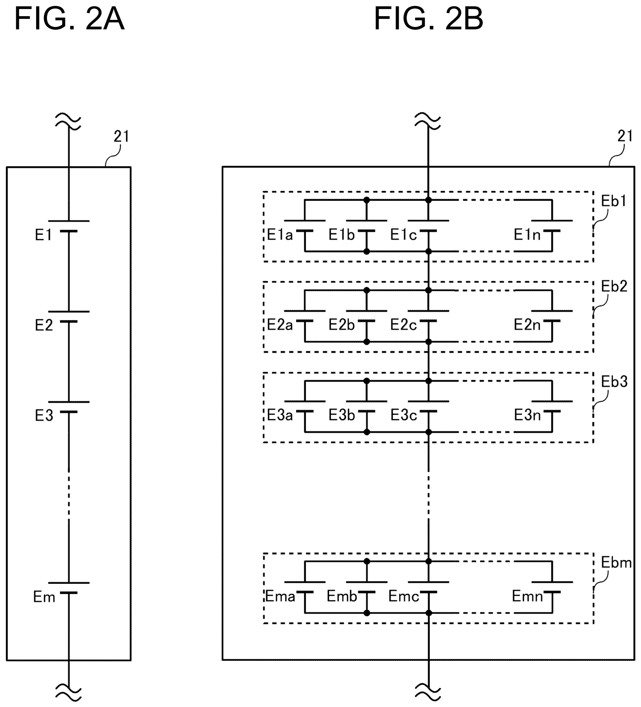

FIG. 2A is a diagram illustrating the configuration of an assembled battery system including single cells E1-Em connected in series. FIG. 2B is a diagram illustrating the configuration of an assembled battery system including cell blocks Eb1-Ebm connected in series. The cell blocks Eb1-Ebm include a plurality of cells E1a-E1n to Ema-Emn connected in parallel.

Lithium ion battery cells, nickel hydride battery cells, lead battery cells, and other types of cells can be used as the cells. Hereinafter, in the present specification, an example of using lithium ion battery cells (nominal voltage: 3.6-3.7 V) is assumed. The number of the single cells or the cell blocks connected in series is determined, based on the voltage of a motor for driving.

Voltage sensor 22 is configured to detect voltages at both ends of each of the single cells or cell blocks connected in series. A shunt resistance is connected in series to the single cells or cell blocks connected in series. Current sensor 23 is configured to detect an electric current flowing through the single cells or cell blocks connected in series, based on voltages at both ends of the shunt resistance. Note that a Hall element may be used, instead of the shunt resistance. A plurality of temperature sensors 24 is installed in the battery pack including assembled battery system 21. For example, a thermistor can be used as temperature sensor 24.

Control unit 25 is configured with a combination of a battery management unit (BMU) and an electronic control unit (ECU). The BMU estimates a SOC by using an open circuit voltage (OCV) method and a current integration method in combination. The OCV method is a method of estimating a SOC, based on the OCV of a cell to be measured and the SOC-OCV curve of the cell. The SOC-OCV curve of the cell is produced in advance, based on a characteristic test performed by a battery manufacturer, and registered in the BMU at the time of shipment.

The current integration method is a method of estimating a SOC, based on the OCV of a cell at the start of charge/discharge and an integrated value of measured currents. In the current integration method, current measurement errors accumulate as charge-and-discharge time becomes longer. Therefore, a weighted average of the SOC estimated by the current integration method and the SOC estimated by the OCV method is preferably used.

The BMU sends battery data including the voltages, currents, temperatures, and SOCs of the single cells or cell blocks constituting assembled battery system 21 to the ECU periodically (for example, every 10 seconds) via an onboard network, whereby the ECU samples battery data on a time-series basis. For example, a controller area network (CAN) or a local interconnect network (LIN) can be used as the onboard network.

Communication unit 26 has the function of executing communication signal processing with communication unit 33 of charge stand 30 and the function of executing radio signal processing for connecting to network 5. For example, communication unit 26 can access network 5 by using a mobile phone network (a cellular network), wireless LAN, Vehicle to Infrastructure (V2I), Vehicle to Vehicle (V2V), an electronic toll collection system (ETC system), or dedicated short range communications (DSRC).

Network 5 is a generic term for communication channels, such as the Internet, dedicated lines, and virtual private networks (VPN), and any communication medium and any protocol can be applied thereto. Examples of the communication medium that can be used include a mobile phone network, wireless LAN, wired LAN, an optical fiber network, an ADSL network, and a CATV network. Examples of the communication protocol that can be used include Transmission Control Protocol (TCP)/Internet Protocol (IP), User Datagram Protocol (UDP)/IP, or Ethernet (registered trademark).

Every time the ECU receives battery data from the BMU, the ECU may send the battery data to battery abnormality detection system 10 or may store the battery data in an internal memory and simultaneously send the battery data stored in the memory to battery abnormality detection system 10 at a predetermined timing. Note that, in a state in which electric vehicle 20 and charge stand 30 are connected by a charging cable, the ECU may send the battery data stored in the memory to battery abnormality detection system 10 via charge stand 30.

The ECU may send all or part of the battery data received from the BMU to battery abnormality detection system 10. For example, for data compression, the ECU may send, as voltage data of the battery pack, the maximum and minimum voltages out of voltages of the single cells or cell blocks constituting assembled battery system 21. Similarly, the ECU may send, as temperature data of the battery pack, the maximum and minimum temperatures out of temperatures measured at a plurality of measurement points in the battery pack.

Alternatively, the ECU may estimate the SOC of the battery pack, based on the SOCs of the single cells or cell blocks constituting assembled battery system 21, and send only the SOC of the battery pack. For example, the ECU can convert the SOCs of the single cells or cell blocks to their actual capacities, synthesize the actual capacities to calculate the actual capacity of the battery pack, and estimate the SOC of the battery pack, based on the actual capacity and the present full charge capacity of the battery pack.

By connecting electric vehicle 20 to charge stand 30 with a charging cable, assembled battery system 21 in electric vehicle 20 can be charged from the outside. Charge stand 30 is connected to commercial power system 2 and charges assembled battery system 21.

In general, AC charge is applied for normal charge, meanwhile DC charge is applied for quick charge. When AC charge (for example, single phase 100/200 V) is applied, a charge voltage or a charge current is controlled by a charger (not illustrated) in electric vehicle 20. When DC charge is applied, a charge voltage or a charge current is controlled by power supply unit 31 of charge stand 30. Power supply unit 31 includes a rectifier circuit, a filter, and a DC/DC converter. AC power supplied from commercial power system 2 is rectified through full-wave rectification by the rectifier circuit and smoothed with the filter, whereby DC power is generated. The DC/DC converter controls the voltage or current of the generated DC power.

As quick charge standards, for example, CHAdeMO (registered trademark), ChaoJi, GB/T, and a combined charging system (Combo) can be used. In CHAdeMO, ChaoJi, and GB/T, CAN is used as a communication protocol. In Combo, power line communication (PLC) is used as a communication protocol.

A charging cable for which the CAN protocol is used includes a communication line as well as a power line. When electric vehicle 20 and charge stand 30 are connected by the charging cable, control unit 25 of electric vehicle 20 establishes a communication channel with control unit 32 of charge stand 30. Note that, in a charging cable for which the PLC protocol is used, a communication signal is superimposed on the power line and transmitted.

Communication unit 33 of charge stand 30 has the function of executing communication signal processing to communicate with communication unit 26 of electric vehicle 20 and the function of executing signal processing to connect to network 5. Communication unit 33 can access network 5 by using, for example, a wired LAN, a wireless LAN, or a cellular network.

Battery abnormality detection system 10 includes control unit 11, memory unit 12, and communication unit 13. Communication unit 13 is a communication interface (for example, network interface card (NIC)) for connecting to network 5 by a wired or wireless means.

Control unit 11 includes data acquisition unit 111, data preprocessing unit 112, and determination unit 113. The function of control unit 11 can be realized by a combination of hardware and software resources or by a hardware resource alone. Examples of the hardware resource that can be used include CPU, ROM, RAM, a graphics processing unit (GPU), an application specific integrated circuit (ASIC), a field programmable gate array (FPGA), and other LSIs. Examples of the software resource that can be used include programs such as operating systems and applications.

Memory unit 12 includes a non-volatile recording medium such as HDD or SSD and stores various types of data. Memory unit 12 includes battery data retention unit 121. Data acquisition unit 111 is configured to acquire battery data from electric vehicle 20 or charge stand 30 and accumulate the acquired battery data in battery data retention unit 121. In the present embodiment, the battery data include the maximum and minimum voltages of the cells or cell blocks in the battery pack, the maximum and minimum temperatures at the observation points in the battery pack, a current flowing through the battery pack, and the SOC of the battery pack. Herein, the programs may be recorded in advance in memory unit 12, or alternatively may be provided through a telecommunications line such as the Internet or may be recorded on a (non-transitory) recording medium such as a memory card and provided.

Data processing unit 112 reads battery time-series data of the battery pack to be analyzed from battery data retention unit 121. For example, data processing unit 112 reads one month's battery data as an analysis target period's data.

As basic processing for detecting a micro short circuit, data processing unit 112 calculates the voltage difference between the maximum and minimum voltages of the cells or cell blocks on a time-series basis. Determination unit 113 determines that, when an increasing rate of the voltage difference exceeds a threshold, a micro short circuit has occurred in a cell or a cell block having the minimum voltage. With this basic processing, detection accuracy decreases when there is a SOC or SOH difference between the cells or the cell blocks.

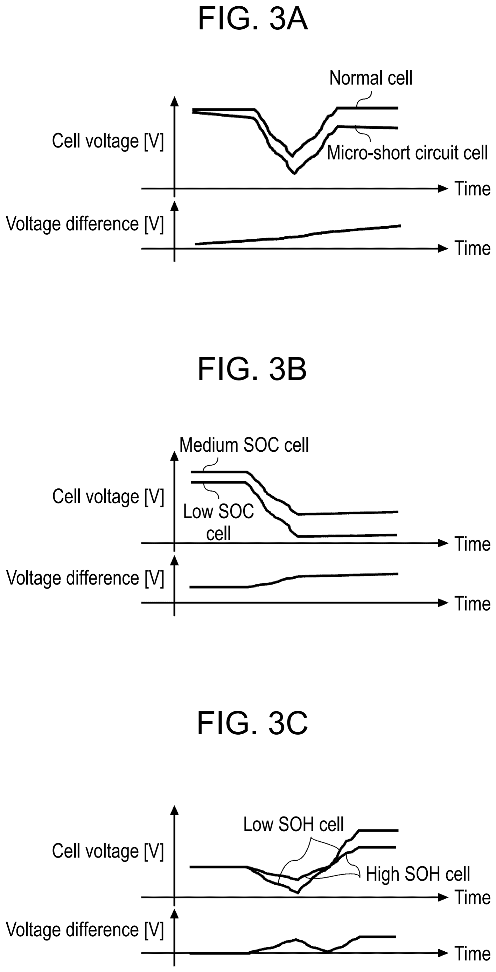

FIG. 3A is a diagram illustrating changes in the cell voltage and the voltage difference of a battery pack in which a micro short circuit has occurred. FIG. 3B is a diagram illustrating changes in the cell voltage and the voltage difference of a battery pack in which a large SOC difference has occurred. FIG. 3C is a diagram illustrating changes in the cell voltage and the voltage difference of a battery pack in which a large SOH difference has occurred.

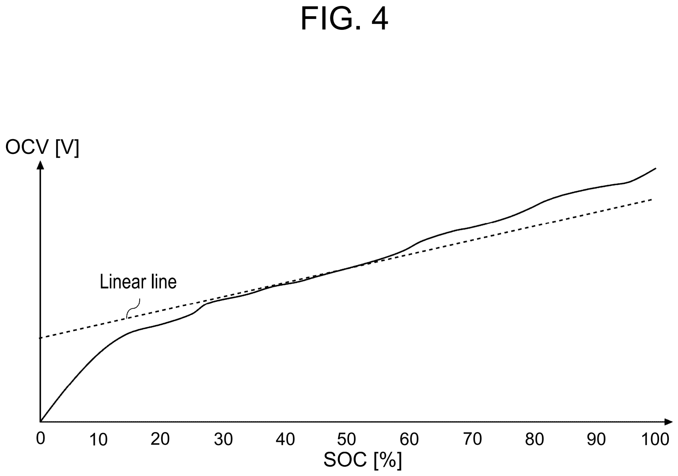

Since a cell in which a micro short circuit has occurred slightly consumes power, the difference between the voltage of the micro short-circuit cell and the voltage of a normal cell gradually becomes wider as illustrated in FIG. 3A. As illustrated in FIG. 3B, the voltage of a low SOC cell more sharply decreases, compared to the voltage of a medium SOC cell. In a cell that exhibits a later-described SOC-OCV curve illustrated in FIG. 4, OCV decreases sharply in a less than 15% SOC range. For example, when a cell having 15% or higher SOC and a cell having less than 15% SOC coexist, the voltage difference between the cells becomes wider even when no micro short circuit has occurred.

As illustrated in FIG. 3C, the voltage of a low SOH cell varies at a higher rate than the voltage of a high SOH cell. Since the capacity of the low SOH cell is small, the voltage greatly changes with a small current. Therefore, when the low SOH cell and the high SOC cell coexist, a period in which the voltage difference between the cells becomes wider or narrower occurs even when no micro short circuit occurs.

FIG. 4 is a diagram illustrating a method of normalizing a cell voltage by producing a linear line that approximates the SOC-OCV curve of a cell. This method can solve a problem in that the detection accuracy of a micro short circuit decreases in a battery pack exhibiting the occurrence of a great difference in SOC as illustrated in FIG. 3B.

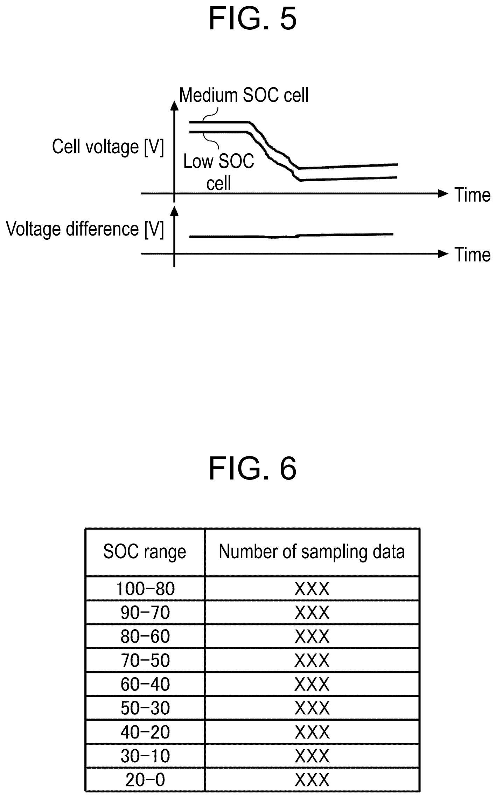

FIG. 5 is a diagram illustrating changes in the voltage of a medium SOC cell, the voltage of a low SOC cell, and the voltage difference when the voltage of the medium SOC cell and the voltage of the low SOC are normalized using the linear line illustrated in FIG. 4. In the example illustrated in FIG. 5, an increase in voltage difference is substantially prevented, which can prevent false detection by which the occurrence of a micro short circuit is mistakenly detected even though no micro short circuit has occurred.

However, this method needs a high-quality SOC-OCV curve of a cell included in a battery pack as an analysis target and cannot be used when the SOC-OCV curve of a cell is unclear. In addition, when the SOC-OCV curve of the cell greatly changes from the initial state due to deterioration, the detection accuracy of a micro short circuit decreases.

In addition, this method is effective for a relatively low-capacity battery pack that allows an increase in voltage difference between cells due to a micro short circuit to be detected at an early stage, but the method is not effective for a large-capacity battery pack that cannot allow an increase in voltage difference between cells due to a micro short circuit to be detected unless a plurality of charge and discharge cycles is repeated.

In addition, this method cannot reduce the effect of the SOH difference between cells. Note that the SOH difference between cells can be corrected when the present SOH of each cell is grasped. However, the SOH of the entirety of a battery pack is grasped in many cases, but the SOHs of cells included in the battery pack are hardly grasped on an individual basis.

In the present embodiment, whether a micro short circuit has occurred or not is determined using only voltage data in a SOC range exhibiting a stable voltage behavior, whereby the detection accuracy of a micro short circuit is enhanced. Data processing unit 112 counts the number of sampling data in each SOC range for time-series sampling data in an analysis target period. The SOC range is set to be a certain range (for example, 20%). When the unit width of the SOC range is too narrow, it is difficult to secure the number of sampling data, whereas, when the unit width of the SOC range is too wide, there is a high possibility that unstable voltage data are mixed in. Designers can determine the width of the SOC range, based on a large number of battery sampling data.

FIG. 6 is a diagram illustrating a tabulation example of the number of sampling data for each SOC range. In the example illustrated in FIG. 6, there are nine SOC ranges: 100%-80%, 90%-70%, 80%-60%, 70%-50%, 60%-40%, 50%-30%, 40%-20%, 30%-10%, and 20%-0%. Thus, the SOC ranges includes a region overlapping with the previous or subsequent SOC range. Therefore, an appropriate SOC range can be selected even when voltage data are concentrated near a boundary generated by simply dividing a SOC.

From a plurality of SOC ranges, data processing unit 112 selects a SOC range in which the most SOC sampling data are present in the analysis target period, as a SOC range to be used for detecting a micro short circuit (hereinafter referred to as the usable SOC range). Generally, many users charge a battery pack until the battery pack is fully charged, and leave the battery pack until electric vehicle 20 is used. Therefore, a 100%-80% SOC range is often selected as the usable SOC range.

Data processing unit 112 deletes voltage data in a section in which the SOC of the battery pack is present in a SOC range other than the usable SOC range, and performs linear interpolation of voltage data for the deleted section, based on voltage data of previous or subsequent sections.

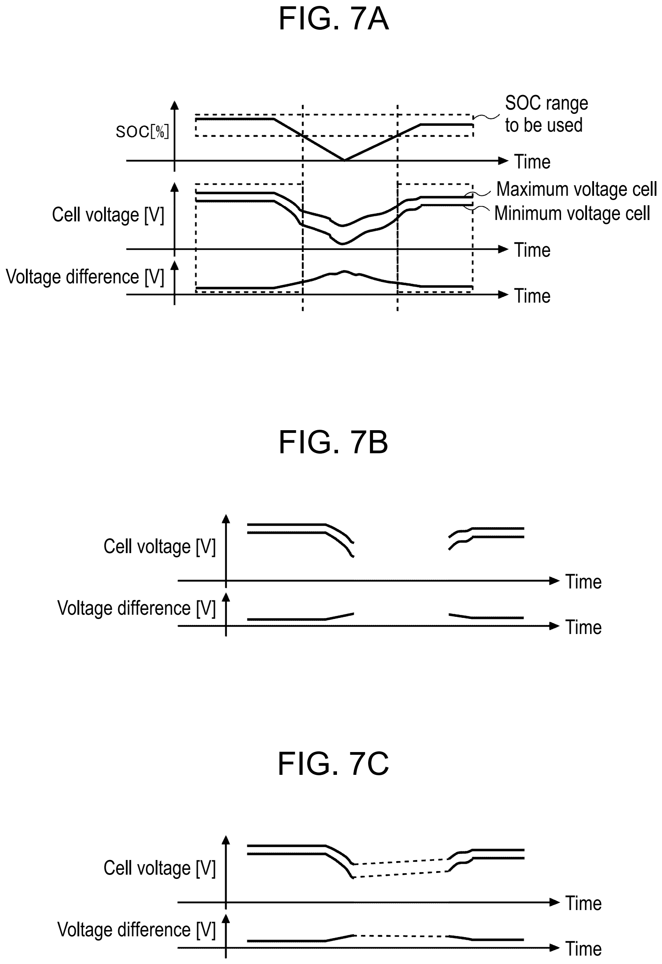

FIG. 7A is a diagram illustrating the way of selecting the usable SOC range, based on changes in the maximum cell voltage, the minimum cell voltage, and the voltage difference therebetween. FIG. 7B is a diagram in which voltage data in a SOC range other than the usable SOC range are deleted. FIG. 7C is a diagram illustrating linear interpolation for a section of the deleted voltage data.

In FIG. 7A, a section framed by a dotted line is a section in which the SOC of a battery pack is present in the usable SOC range. Voltage data in a section other than the usable SOC range vary more greatly than voltage data in the section of the usable SOC range, and therefore are deleted as illustrated in FIG. 7B.

Data processing unit 112 estimates voltage data at time points in the deleted section by linear interpolation, based on voltage data at the end of the usable SOC range immediately before the deleted section and voltage data at the beginning of the usable SOC range immediately after the deleted section, and interpolates the estimated voltage data in the deleted section. When no section of the usable SOC range is present before or after the deleted section, data processing unit 112 may interpolate voltage data of the deleted section by linear extrapolation. Polynomial interpolation such as spline interpolation may be used.

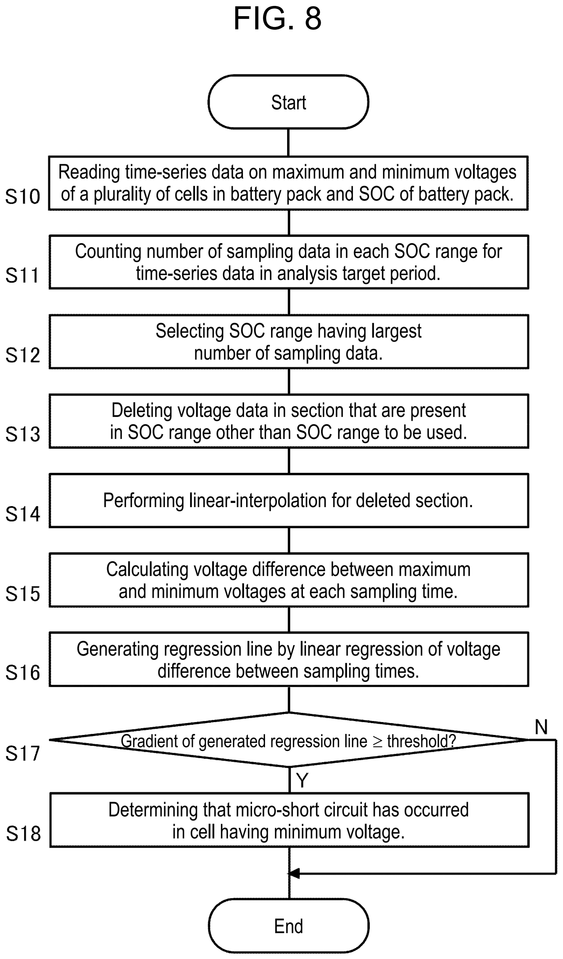

FIG. 8 is a flowchart illustrating Operation Example 1 of battery abnormality detection system 10 according to the embodiment. As time-series data of a battery pack to be analyzed in an analysis target period, data processing unit 112 reads the maximum and minimum voltages of a plurality of cells or cell blocks and the SOC of the battery pack from battery data retention unit 121 (S10).

By using the time-series sampling data included in the analysis target period as a target data, data processing unit 112 checks the SOC at each sampling time and counts sampling data in each SOC range (S11). Data processing unit 112 selects a SOC range having the largest amount of sampling data as the usable SOC range (S12).

Data processing unit 112 deletes voltage data in a section in which the SOC of the battery pack is present in a SOC range other than the usable SOC range (S13). Data processing unit 112 performs linear interpolation of voltage data for the deleted section, based on the previous and subsequent voltage data (S14). Data processing unit 112 calculates a voltage difference between the maximum and minimum voltages at each sampling time in the analysis target period (S15). Here, data processing unit 112 may refer to a cell number of a cell or cell block having the minimum voltage at each sampling time and calculate only a voltage difference between the minimum voltage of the cell or cell block having the most cell numbers and the maximum voltage at the corresponding sampling time. Data processing unit 112 generates a regression line by linear regression of the voltage difference between a plurality of sampling times included in the analysis target period (S16).

When the gradient of the generated regression line is equal to or greater than a threshold (Y at S17), determination unit 113 determines that a micro short circuit has occurred in the cell or cell block having the minimum voltage. When the gradient of the generated regression line is less than the threshold (N at S17), determination unit 113 determines that no micro short circuit has occurred in the cell or cell block having the minimum voltage.

The analysis target period and the threshold are determined based on the capacity of the battery pack and a short circuit resistance that shall be determined as a micro short circuit. For example, when a micro short circuit of 200 Ω has occurred in a 140-Ah battery pack, a voltage difference of approximately 3 mV between a normal cell and a micro short circuit cell occurs in one day. This voltage difference is difficult to distinguish from a voltage difference caused by a measurement error or a temperature environment. Therefore, for the 140-Ah battery pack, an analysis target period of 14 to 30 days is desirably set. Thus, when the battery pack has a small capacity, the analysis target period can be made shorter, whereas, when the battery pack has a large capacity, the analysis target period needs to be made longer.

In the description above, a SOC range having the largest number of records of sampling data out of a plurality of SOC ranges is used as the usable SOC range. Here, the SOC range having the largest number of records of sampling data is not necessarily in agreement with a SOC range having the most stable voltage. For example, a moderate SOC range is more likely to be selected when the frequency of full charging is low.

Voltage data basically tends to be more accurate in a region with a shallower discharge depth. In a region with a deeper discharge depth, the effect of an internal resistance change associated with a temperature change is greater. When the moderate SOC range is selected, there is a possibility that the accuracy of voltage data and SOC data is low.

In Operation Example 2, out of a plurality of SOC ranges, a SOC range having the longest total charge-and-discharge suspension period is selected as the usable SOC range. The suspension period shall be a period having no current data. Note that, in some battery packs, when a current value measured by current sensor 23 is kept 0 during a certain period, BMU goes on standby. When the BMU is on standby, battery data are basically missing. The data missing section may be regarded as the suspension period, or the data missing section may not be regarded as the suspension period, in consideration of a possibility that the data missing occurs due to a factor other than the standby of the BMU (such as data missing during data transmission). Alternatively, the data missing section may be regarded as the suspension period only when no current data are present just before and after the data missing section.

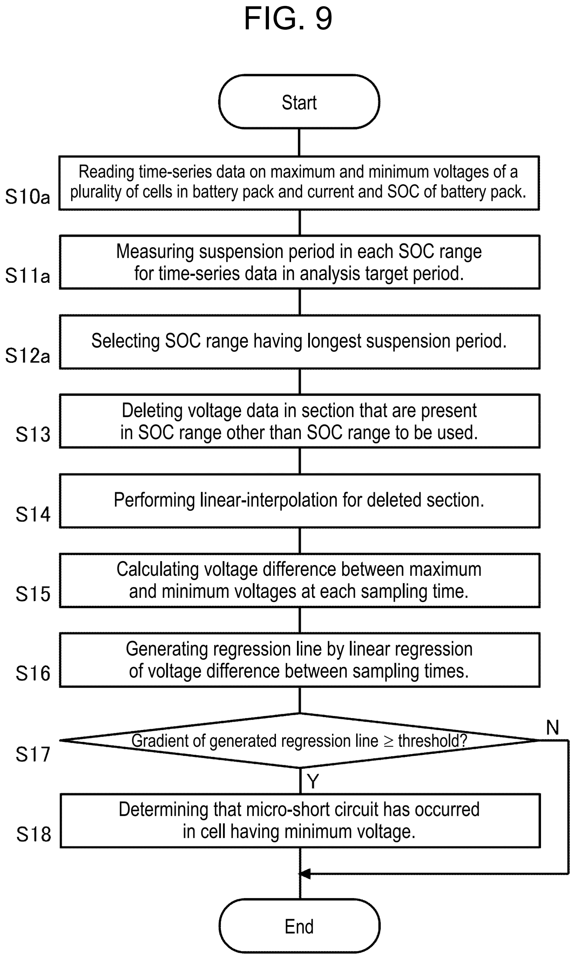

FIG. 9 is a flowchart illustrating Operation Example 2 of battery abnormality detection system 10 according to the embodiment. As time-series data of a battery pack to be analyzed in an analysis target period, data processing unit 112 reads the maximum and minimum voltages of a plurality of cells or cell blocks and the SOC of the battery pack from battery data retention unit 121 (S10a).

By using the time-series sampling data included in the analysis target period as target data, data processing unit 112 checks a current at each sampling time and measures a suspension period for each SOC range (S11a). Data processing unit 112 selects a SOC range having the longest suspension period as the usable SOC range (S12a). Processing at and after step S13 is similar to the processing at and after step S13 illustrated in the flowchart in FIG. 8.

Note that, to select a SOC range having stable voltage data, data processing unit 112 calculates the standard deviation of voltage data included in each SOC range, and a SOC range having the smallest standard deviation may be selected as the usable SOC range. Here, to secure a certain number of sampling data, out of SOC ranges having a predetermined number or more of sampling data, data processing unit 112 may select the SOC range having the smallest standard deviation of voltage data as the usable SOC range.

As described above, according to the present embodiment, an increasing rate of voltage difference between the maximum voltage and the minimum voltage is calculated by using voltage data in a period in which the SOC of a battery pack is present in the usable SOC range, and, when the increasing rate is equal to or greater than a threshold, it is determined that a micro short circuit has occurred. Thus, a micro short circuit in the battery pack can be detected with high accuracy. By using the voltage data in the SOC range having stable voltage, the effect of a SOC change on voltage difference can be substantially prevented, and, even when a large difference in SOC or SOH between a plurality of cells or cell blocks occurs, the presence or absence of a micro short circuit can be determined with high accuracy. In addition, since the SOC-OCV curve of a cell is not required, a wider range of battery packs can be analyzed.

Hereinbefore, the present disclosure has been described, based on the embodiment. Persons skilled in the art understand that the embodiment is merely an example, and various modifications can be made to combinations of the constituents or combinations of the processing steps, and such modifications are also included within the scope of the present disclosure.

In the above-described embodiment, data processing unit 112 calculates the voltage difference between the maximum and minimum voltages of a plurality of cells or cell blocks connected in series. Here, the maximum voltage is an example of a reference voltage for calculating a difference from the minimum voltage. Instead of the maximum voltage, data processing unit 112 may, for example, use the median or average of voltages of the cells or cell blocks as the reference voltage. When calculating the median or average of the voltages, data processing unit 112 may calculate the median or average without using the maximum and minimum of the voltages. The median and average may be generated by the BMU and transmitted to battery abnormality detection system 10.

In the above-described embodiment, described is an example in which a micro short circuit in a battery pack installed in electric vehicle 20 is detected by battery abnormality detection system 10 connected to network 5. Here, battery abnormality detection system 10 may be incorporated in control unit 25. Alternatively, battery abnormality detection system 10 may be incorporated in charge stand 30.

In the above-described embodiment, a four-wheel electric vehicle is assumed as electric vehicle 20. Here, electric vehicle 20 may be an electric motorbike (an electric scooter), an electric-assisted bicycle, or an electric kickscooter. Examples of the electric vehicle include not only full-standard electric vehicles, but also low-speed electric vehicles such as golf carts and land cars. Equipment in which the battery pack is installed is not limited to electric vehicle 20. Examples of the equipment in which the battery pack is installed also include electric ships, railway vehicles, electric mobile objects such as multicopters (drones), stationary energy storage systems, consumer electronic devices (such as smart phones and notebook PCs).

Note that the embodiment may be specified by the following items.

### [Item 1]

A battery abnormality detection system (10), including:
a data acquisition unit (111) configured to acquire time-series data on a plurality of voltages, including the minimum voltage, of a plurality of cells (E1-Em) included in a battery pack and connected in series, or a plurality of voltages, including the minimum voltage, of a plurality of cell blocks (Eb1-Ebm) included in a battery pack and connected in series, each of the cell blocks including a plurality of cells (El-Em), and SOC of the battery pack;
a data processing unit (112) configured to calculate a voltage difference between a reference voltage and the minimum voltage of each of the cells (E1-Em) or the cell blocks (Eb1-Ebm) on a time-series basis; and
a determination unit (113) configured to, when an increasing rate of the voltage difference is equal to or greater than a threshold, determine that a micro short circuit has occurred in the cells (E1-Em) or the cell blocks (Eb1-Ebm) having the minimum voltage,
wherein the data processing unit (112) calculates the increasing rate of the voltage difference by using voltage data in a period in which the SOC of the battery pack is within a predetermined SOC range.

Thus, a micro short circuit in the battery pack including the cells (E1-Em) or the cell blocks (Eb1-Ebm) connected in series is detected with high accuracy.

### [Item 2]

The battery abnormality detection system (10) according to Item 1, wherein the data processing unit (112) selects, as the predetermined SOC range, a SOC range having the largest amount of SOC sampling data present in an analysis target period for the time-series data, from a plurality SOC ranges.

Thus, the presence or absence of a micro short circuit can be determined, based on voltage data in a SOC range in which the voltage behavior is highly likely to be stable.

### [Item 3]

The battery abnormality detection system (10) according to Item 1, wherein
the data acquisition unit (111) acquires current time-series data of the battery pack, and
the data processing unit (112) selects a SOC range having the longest total charge-and-discharge suspension period from a plurality SOC ranges, as the predetermined SOC range.

Thus, the presence or absence of a micro short circuit can be determined, based on voltage data in a SOC range in which the voltage behavior is highly likely to be stable.

### [Item 4]

The battery abnormality detection system (10) according to Item 2 or 3, wherein the data processing unit (112) deletes voltage sampling data present in a SOC range other than the predetermined SOC range and performs linear interpolation for a section of the deleted voltage sampling data.

Thus, the number of samples of voltage data can be ensured.

### [Item 5]

The battery abnormality detection system (10) according to Item 2 or 3, wherein the SOC ranges include an overlapping region.

Thus, an appropriate SOC range can be selected even when voltage data are concentrated near a boundary generated when SOC is simply divided.

### [Item 6]

A battery abnormality detection method, including:
acquiring time-series data on a plurality of voltages, including the minimum voltage, of a plurality of cells (E1-Em) included in a battery pack and connected in series, or a plurality of voltages, including the minimum voltage, of a plurality of cell blocks (Eb1-Ebm) included in a battery pack and connected in series, each of the cell blocks including a plurality of cells (E1-Em), and SOC of the battery pack;
calculating a voltage difference between a reference voltage and the minimum voltage of each of the cells (E1-Em) or the cell blocks (Eb1-Ebm) on a time-series basis; and
determining that a micro short circuit has occurred in the cells (E1-Em) or the cell blocks (Eb1-Ebm) having the minimum voltage, when an increasing rate of the voltage difference is equal to or greater than a threshold,
wherein the calculating includes calculating the increasing rate of the voltage difference by using voltage data in a period in which the SOC of the battery pack is within a predetermined SOC range.

Thus, a micro short circuit in the battery pack including the cells (El-Em) or the cell blocks (Eb1-Ebm) connected in series is detected with high accuracy.

### [Item 7]

A battery abnormality detection program causing a computer to execute:
acquiring time-series data on a plurality of voltages, including the minimum voltage, of a plurality of cells (E1-Em) included in a battery pack and connected in series, or a plurality of voltages, including the minimum voltage, of a plurality of cell blocks (Eb1-Ebm) included in a battery pack and connected in series, each of the cell blocks including a plurality of cells (E1-Em), and SOC of the battery pack;
calculating a voltage difference between a reference voltage and the minimum voltage of each of the cells (E1-Em) or the cell blocks (Ebl-Ebm) on a time-series basis; and
determining that a micro short circuit has occurred in the cells (E1-Em) or the cell blocks (Eb1-Ebm) having the minimum voltage, when an increasing rate of the voltage difference is equal to or greater than a threshold,
wherein the calculating includes calculating the increasing rate of the voltage difference by using voltage data in a period in which the SOC of the battery pack is within a predetermined SOC range.

Thus, a micro short circuit in the battery pack including the cells (E1-Em) or the cell blocks (Eb1-Ebm) connected in series is detected with high accuracy.

### REFERENCE MARKS IN THE DRAWINGS

- 2: commercial power system
- 5: network
- 10: battery abnormality detection system
- 11: control unit
- 12: memory unit
- 13: communication unit
- 20: electric vehicle
- 21: assembled battery system
- 22: voltage sensor
- 23: current sensor
- 24: temperature sensor
- 25: control unit
- 26: communication unit
- 30: charge station
- 31: power supply unit
- 32: control unit
- 33: communication unit
- 111: data acquisition unit
- 112: data processing unit
- 113: determination unit
- 121: battery data retention unit

## Claims

1. A battery abnormality detection system, comprising:
a data acquisition unit configured to acquire time-series data including
a plurality pieces of voltage data including
a plurality of voltages, including a minimum voltage, of a plurality of cells included in a battery pack and connected in series, or
a plurality of voltages, including a minimum voltage, of a plurality of cell blocks included in a battery pack and connected in series, each of the cell blocks including a plurality of cells, and
a plurality pieces of state-of-charge data including a plurality of state-of-charges of the battery pack;
a data processing unit configured to calculate a voltage difference between a reference voltage and a minimum voltage of each of the cells or each of the cell blocks on a time-series basis as a plurality of voltage difference data; and
a determination unit configured to, when an increasing rate of the voltage difference is equal to or greater than a threshold, determine that a micro short circuit occurs in the plurality of cells having the minimum voltage or the plurality of cell blocks having the minimum voltage,
wherein the data processing unit calculates the increasing rate of the voltage difference in each of the cells or each of the cell blocks by using the voltage data in a period in which a state-of-charge of the battery pack is within a predetermined state-of-charge range.

2. The battery abnormality detection system according to Claim 1,
wherein the data processing unit selects a state-of-charge range having a largest number of SOC sampling data present in an analysis target period for the time-series data from a plurality state-of-charge ranges, as the predetermined state-of-charge range.

3. The battery abnormality detection system according to Claim 1, wherein
the data acquisition unit acquires a plurality piece of current time-series data of the battery pack, and
the data processing unit selects a state-of-charge range having a longest total charge-and-discharge suspension periods from a plurality state-of-charge ranges, as the predetermined State-Of-Charge range.

4. The battery abnormality detection system according to Claim 2 or 3, wherein the data processing unit deletes voltage sampling data present in a state-of-charge range other than the predetermined state-of-charge range and performs linear interpolation for a section of the voltage sampling data deleted.

5. The battery abnormality detection system according to Claim 2 or 3, wherein the state-of-charge ranges include an overlapping region.

6. A battery abnormality detection method, comprising:
acquiring time-series data including
a plurality piece of voltage data including
a plurality of voltages, including a minimum voltage, of a plurality of cells included in a battery pack and connected in series, or
a plurality of voltages, including a minimum voltage, of a plurality of cell blocks included in a battery pack and connected in series, each of the cell blocks including a plurality of cells, and
a plurality of piece state-of-charge data including a plurality of state-of-charges of the battery pack;
calculating a voltage difference between a minimum voltage and a reference voltage of each of the cells or each of the cell blocks on a time-series basis, as a plurality of voltage difference data; and
determining that a micro short circuit occurs in the plurality of cells having the minimum voltage or the cell blocks having the minimum voltage, when an increasing rate of the voltage difference is equal to or greater than a threshold,
wherein the calculating includes calculating the increasing rate of the voltage difference by using voltage data in a period in which a state-of-charge of the battery pack is within a predetermined state-of-charge range.

7. A battery abnormality detection program causing a computer to execute:
acquiring time-series data including
a plurality of voltage data including
a plurality of voltages, including a minimum voltage, of a plurality of cells included in a battery pack and connected in series, or
a plurality of voltages, including a minimum voltage, of a plurality of cell blocks included in a battery pack and connected in series, each of the cell blocks including a plurality of cells, and
a plurality of state-of-charge data including a plurality of state-of-charges of the battery pack;
calculating a voltage difference between a reference voltage and a minimum voltage of each of the cells or each of the cell blocks on a time-series basis, as a plurality of voltage difference data; and
determining that a micro short circuit occurs in the cells having the minimum voltage or the cell blocks having the minimum voltage, when an increasing rate of the voltage difference is equal to or greater than a threshold,
wherein the calculating includes calculating the increasing rate of the voltage difference by using voltage data in a period in which a state-of-charge of the battery pack is within a predetermined state-of-charge range.

8. A non-transitory recording medium on which the battery abnormality detection program according to Claim 7 is recorded.
